# EUROPEAN PATENT SPECIFICATION

(11) **EP 3 678 003 B1**
(45) Date of publication and mention of the grant of the patent: **25.09.2024**
(21) Application number: 19215763.4
(22) Date of filing: 12.12.2019
(51) Int. Cl.: G06F 3/041, G06F 3/042, G06F 1/16

(54) **DISPLAY DEVICE**
ANZEIGEVORRICHTUNG
DISPOSITIF D'AFFICHAGE

(30) Priority: 03.01.2019 US 201916238635
(43) Date of publication of application: 08.07.2020
(73) Proprietor: InnoLux Corporation, Chu-Nan, Miao-Li 350 (TW)
(72) Inventor: LIUS, Chandra, 350 Miao-Li County (TW); LEE, Kuan-Feng, 350 Miao-Li County (TW)
(74) Representative: 2K Patentanwälte Blasberg Kewitz & Reichel

(56) References cited:
- EP-A1- 2 237 104
- WO-A1-2018/150989
- US-A1- 2005 200 293
- US-A1- 2010 007 632
- US-A1- 2015 228 704
- US-A1- 2018 157 083
- US-A1- 2019 391 431

## Description

### BACKGROUND

### Technical Field

The present disclosure relates to a display device comprising a substrate, a driving circuit, a plurality of sensing units and a plurality of display units.

### Description of the Related Art

Electronic products that include a display device, such as smartphones, tablets, notebook computers, monitors, and TVs, have become indispensable necessities in modern society. With the flourishing development of such portable electronic products, consumers have high expectations regarding the quality, functionality, and price of such products. These electronic products are often provided with fingerprint identification functionality to control access. However, existing display devices have not been satisfactory in every respect.

US 2015/228704 A1 discloses a display device that is suitable for increasing in size, a display device in which display unevenness is suppressed, or a display device that can display an image along a curved surface. The display device includes a first display panel and a second display panel each including a pair of substrates. The first display panel and the second display panel each include a first region which can transmit visible light, a second region which can block visible light, and a third region which can perform display. The third region of the first display panel and the first region of the second display panel overlap each other. The third region of the first display panel and the second region of the second display panel do not overlap each other.

US 2010/007632 A1 discloses a semiconductor device which includes a display portion and a driver circuit portion configured to drive the display portion. The display portion includes a first pixel electrode, a second pixel electrode, a plurality of photo sensors between the first pixel electrode and the second pixel electrode, and a plurality of color filters. The driver circuit portion includes a transistor including a single crystal semiconductor layer.

Therefore, a new display device that improves display quality is needed.

### SUMMARY

The invention is set out in the appended set of claims. In accordance with all embodiments of the present disclosure, a display device is provided. The display device includes a substrate. The display device also includes a driving circuit disposed on the substrate. The driving circuit includes a semiconductor layer. The display device further includes a plurality of sensing units disposed on the driving circuit. In addition, the display device includes a plurality of display units driven by the driving circuit. The display device further includes a sensing circuit electrically connected to at least one of the plurality of sensing units. At least one of the plurality of sensing units overlaps the semiconductor layer of the driving circuit and at least a portion of the sensing circuit overlaps at least a portion of the driving circuit, wherein the plurality of sensing units are disposed between the driving circuit and the plurality of display units. A wire is disposed on the driving circuit, wherein the wire electrically connects the driving circuit and the plurality of display units.

A detailed description is given in the following embodiments with reference to the accompanying drawings.

### BRIEF DESCRIPTION OF THE DRAWINGS

The disclosure may be understood by reading the subsequent detailed description and examples with references made to the accompanying drawings, wherein:
FIGs. 1-7 illustrate cross-sectional views of the display device containing organic light-emitting diode (OLED) FIGs. 1-2 and 5-7 being in accordance with some embodiments of the present disclosure; FIGs 3 and 4 not being covered by the claims.
FIGs. 8-12 illustrate cross-sectional views of the display device containing a liquid-crystal display (LCD), FIGs. 8-9 and 12 being in accordance with some embodiments of the present disclosure; FIGs. 10 and 11 not being covered by the claims.
FIGs. 13-15 illustrate top views of the display device in accordance with some embodiments of the present disclosure.
FIG. 16A illustrates a top view of the display device in accordance with some embodiments of the present disclosure.
FIG. 16B illustrates a cross-sectional view of the display device shown in FIG. 16A in accordance with some embodiments of the present disclosure.
FIG. 17A illustrates a top view of the display device in accordance with some embodiments of the present disclosure.
FIG. 17B illustrates a cross-sectional view of the display device shown in FIG. 17A in accordance with some embodiments of the present disclosure.

### DETAILED DESCRIPTION

The display device of the present disclosure and the manufacturing method thereof are described in detail in the following description. In the following detailed description, for purposes of explanation, numerous specific details and embodiments are set forth in order to provide a thorough understanding of the present disclosure. It will be apparent, however, that the exemplary embodiments set forth herein are used merely for the purpose of illustration, and the inventive concept may be embodied in various forms without being limited to those exemplary embodiments. In addition, the drawings of different embodiments may use like and/or corresponding numerals to denote like and/or corresponding elements. However, the use of like and/or corresponding numerals in the drawings of different embodiments does not suggest any correlation between different embodiments. In addition, in this specification, expressions such as "first material layer disposed above/on/over a second material layer", may indicate the direct contact of the first material layer and the second material layer, or it may indicate a non-contact state with one or more intermediate layers between the first material layer and the second material layer. In the above situation, the first material layer may not be in direct contact with the second material layer.

In addition, in this specification, relative expressions are used. For example, "upper" or "lower" is used to describe the position of one element relative to another. It should be appreciated that if a device is flipped upside down, an element that is on the "bottom" will become an element that is on the "top".

It should be understood that, although the terms first, second, third etc. may be used herein to describe various elements, components, regions, layers, portions and/or sections, these elements, components, regions, layers, portions and/or sections should not be limited by these terms. These terms are only used to distinguish one element, component, region, layer, portion or section from another element, component, region, layer or section. Thus, a first element, component, region, layer, portion or section discussed below could be termed a second element, component, region, layer, portion or section without departing from the teachings of the present disclosure.

It should be understood that this description of the exemplary embodiments is intended to be read in connection with the accompanying drawings, which are to be considered part of the entire written description. The drawings are not drawn to scale. In addition, structures and devices are shown schematically in order to simplify the drawing. In the drawings, some components may be omitted for clarity. Moreover, some components in the drawings may be eliminated as another embodiment of the present disclosure.

The terms "about" and "substantially" typically mean +/- 20% of the stated value, more typically +/- 10% of the stated value, more typically +/- 5% of the stated value, more typically +/- 3% of the stated value, more typically +/- 2% of the stated value, more typically +/- 1% of the stated value and even more typically +/- 0.5% of the stated value. The stated value of the present disclosure is an approximate value. When there is no specific description, the stated value includes the meaning of "about" or "substantially". Moreover, when considering the deviation or the fluctuation of the manufacturing process, the term "same" may also include the meaning of "about" or "substantially".

Unless defined otherwise, all technical and scientific terms used herein have the same meaning as commonly understood by one of ordinary skill in the art to which this disclosure belongs. It should be appreciated that, in each case, the term, which is defined in a commonly used dictionary, should be interpreted as having a meaning that conforms to the relative skills of the present disclosure and the background or the context of the present disclosure, and should not be interpreted in an idealized or overly formal manner unless so defined.

In addition, in some embodiments of the present disclosure, terms concerning attachments, coupling and the like, such as "connected" and "interconnected," refer to a relationship wherein structures are secured or attached to one another either directly or indirectly through intervening structures, as well as both movable or rigid attachments or relationships, unless expressly described otherwise.

In addition, the phrase "in a range from a first value to a second value" indicates the range includes the first value, the second value, and other values in between.

In addition, the term "cover" includes the meaning of "cover partially" or "cover completely".

In accordance with some embodiments of the present disclosure, a display device is provided. The display device has a plurality of display units driven by a driving circuit. The display device also has a plurality of sensing units driven by a sensing circuit. At least one of the sensing units overlaps the semiconductor layer of the driving circuit. As a result, the size of the display device can be reduced.

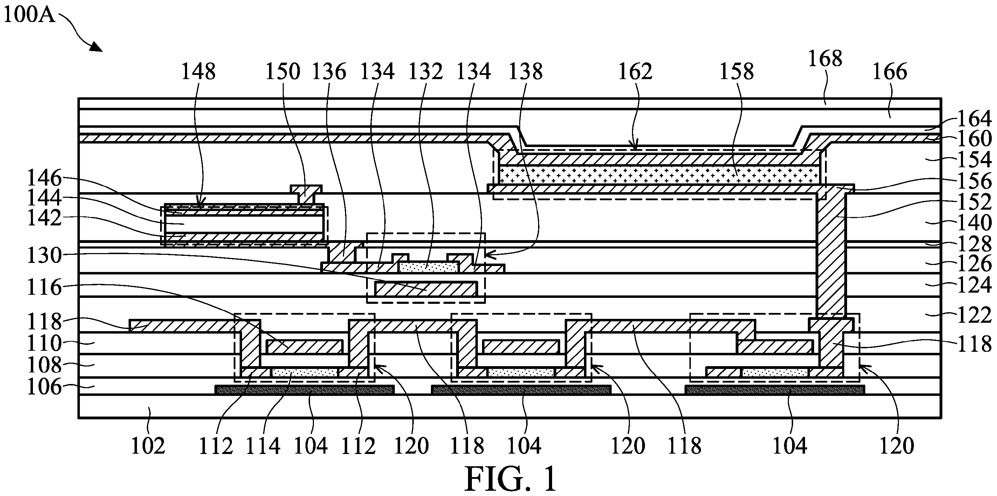

Refer to FIG. 1, which illustrates a cross-sectional view of a display device 100A in accordance with some embodiments of the present disclosure. The display device 100A includes a substrate 102. The substrate 102 may include a glass substrate, a ceramic substrate, a polymer substrate, other suitable substrates, or a combination thereof. The substrate may include a rigid substrate and/or a flexible substrate. A light shielding layer 104 may be disposed on the substrate 102. The light shielding layer 104 may be configured to shield at least a portion of the light affecting the driving circuits, but it is not limited thereto. Though it is not depicted, some buffer layers may be disposed between the substrate 102 and the light shielding layer 104. The material of the light shielding layer 104 may include, but is not limited to, metal, metal oxide, and/or resin materials. Insulating layers 106, 108, and 110 may be sequentially disposed on the substrate 102. The material of the insulating layers 106, 108, and 110 may include, but is not limited to, silicon nitride, silicon oxide, silicon oxynitride, silicon carbide, other dielectric materials, or a combination thereof.

As shown in FIG. 1, the display device 100A includes a plurality of driving circuits 120. At least one of the driving circuits 120 is used to drive display units, but it is not limited thereto. Although FIG. 1 illustrates only three driving circuits 120, the display device 100A may have more driving circuits 120, and the scope of the disclosure is not intended to be limited. In some embodiment, at least one of the driving circuits 120 may include a thin film transistor (TFT). For example, the driving circuit 120 includes a semiconductor layer 114, and a gate electrode 116. In some examples, the semiconductor layer 114 may include a source/drain region 112 and a channel region disposed between the source/drain region 112, but it is not limited thereto. In other examples, the semiconductor layer 114 may include a doped region (e.g. the source/drain region) and a non-doped region. Two adjacent driving circuits 120 may be electrically connected through at least one wire 118. Two adjacent driving circuits may be electrically connected through their source/drain regions 112 and/or at least one wire, but it is not limited thereto. For example, one driving circuit may be electrically connected to the gate electrode of adjacent driving circuits through its source/drain region 112 and/or the wire 118. The semiconductor layer 114 may be disposed on the insulating layer 106. The material of the semiconductor may include, but is not limited to, amorphous silicon, polysilicon such as low-temp polysilicon (LTPS), metal oxide or other suitable materials. The metal oxide may include indium gallium zinc oxide (IGZO), indium zinc oxide (IZO), indium gallium zinc tin oxide (IGZTO), low temperature polycrystalline oxide (LTPO), other suitable materials, or a combination thereof. The material of the gate electrode 116 may include metal, such as copper (Cu), aluminum (Al), molybdenum (Mo), tungsten (W), gold (Au), chromium (Cr), nickel (Ni), platinum (Pt), titanium (Ti).. In some examples, the semiconductor layers 114 of the driving circuits may have different compositions. For example, in the embodiment where the semiconductor layer is the indium gallium zinc oxide (IGZO) layer, the semiconductor layer may include different compositions of In, Ga, Zn and O, such as 1:1:1:4 or other suitable composition(s). In other examples, the semiconductor layers 114 of the driving circuits 120 may include different materials. For example, the material of the semiconductor layer 114 of one driving circuit 120 may include low-temp polysilicon, while the material of the semiconductor layer 114 of another driving circuit 120 may include low temperature polycrystalline oxide, but it is not limited thereto. The stacking structure of the layers of the driving circuit 120 may be adjusted depending on the needs, but it is not limited thereto.

The wire 118 may be used to electrically connect at least a portion of the plurality of driving circuits 120. The wire 118 may be disposed on the insulating layer 110. Moreover, the wire 118 may penetrate the insulating layers 110 and 108. As shown in FIG. 1, the wire 118 may contact with the source/drain region 112 and/or the gate electrode 116 of the driving circuit 120. The material of the wire 118 may be the same as or similar to that of the source/drain region 112.

As shown in FIG. 1, insulating layers 122, 124, 126 and 128 may be sequentially disposed on the insulating layer 110. The material of the insulating layers 122, 124, 126 and 128 may be the same as or similar to that of the insulating layer 106. The material of at least one of the insulating layers 122, 124, 126 and 128 may be different from another one. In some examples, at least one of the insulating layers 122, 124, 126 and 128 may be omitted. In other examples, the display device 100A may have more insulating layers.

In all embodiments, the display device 100A includes at least one sensing circuit 138. The sensing circuit 138 is disposed on the driving circuit 120. The sensing circuit 138 may include a gate electrode 130, a semiconductor layer 132, but is it not limited thereto. In some examples, the semiconductor layer 132 may include a source/drain region 134 and a channel region disposed between the source/drain region 134, but it is not limited thereto. In other examples, the semiconductor layer may include a doped region and a non-doped region. The sensing circuit 138 may be used to drive at least one sensing unit and/or electrically connect to other electronic elements, but it is not limited thereto. The gate electrode 130 may be disposed on the insulating layer 122. The source/drain region 134 may be disposed on the insulating layer 124. The semiconductor layer 132 may be disposed on the insulating layer 124. The material of the gate electrode 130 may be the same as or similar to that of the gate electrode 116. The material of the semiconductor layer 132 may be the same as or similar to that of the semiconductor layer 114. In some examples, the driving circuit and/or the sensing circuit in the present disclosure may include a top gate thin film transistor, a bottom gate thin film transistor, a dual gate thin film transistor, a double gate thin film transistor, other suitable transistors, or a combination thereof.

As shown in FIG. 1, an insulating layer 140 may be disposed on the insulating layer 128. The material of the insulating layer 140 may include, but is not limited to, polyethylene terephthalate (PET), polyethylene (PE), polyethersulfone (PES), polycarbonate (PC), polymethylmethacrylate (PMMA), glass, acrylic-based polymer, siloxane-based polymer, any other suitable materials, or a combination thereof.

In all embodiments, the display device 100A includes at least one sensing unit 148 disposed on at least one of the driving circuits 120. The sensing unit 148 may be used to sense a photonic signal from an object and convert it into an electrical signal, but it is not limited thereto. In some examples, the sensing unit 148 may be a fingerprint sensing unit, a proximity sensing unit, or any other suitable sensing unit. Although FIG. 1 illustrates only one sensing unit 148, the display device 100A may include more sensing units 148, and the scope of the disclosure is not intended to be limited. As shown in FIG. 1, the sensing unit 148 may include a semiconductor layer 142, a photoactive layer 144, and a semiconductor layer 146. The photoactive layer 144 may be disposed between the semiconductor layer 142 and the semiconductor layer 146. In addition, the semiconductor layer 142 and the semiconductor layer 146 may be doped with dopants of different types. For example, the semiconductor layer 142 may include one of n-type dopants and p-type dopants, and the semiconductor layer 146 may include the other one of n-type dopants and p-type dopants. For example, the semiconductor layer 146 may include p-type dopants while the semiconductor layer 142 may include n-type dopants. The photoactive layer 144 may include dopants with low concentration. In some embodiments, the concentration of the dopants of the photoactive layer 144 may be less than that of the semiconductor layer 142 and the semiconductor layer 146. In some embodiments, the sensing unit 148 may be a PIN diode. As shown in FIG. 1, the sensing unit 148 may be electrically connected to the sensing circuit 138 through a wire 136. The sensing unit 148 may be electrically connected to other electronic elements through a wire 150. The material of the wires 136 and 150 may be the same as or similar to that of the wire 118, and is not repeated herein.

In all embodiments, the sensing unit 148 overlaps at least one of the driving circuits 120. The term "overlap" may include partially overlap or entirely overlap in the normal direction of the substrate 102. More specifically, the sensing unit 148 overlaps the semiconductor layer 114 of at least one of the driving circuit 120. Namely, the projection of the sensing unit 148 on the substrate 102 may overlap the projection of the semiconductor layer 114 on the substrate 102. In all embodiments, the sensing unit 148 and the driving circuit 120 are not disposed on the same layer. As a result, this assists in reducing the size of the display device 100A. In some embodiments, both the sensing circuit 138 and the sensing unit 148 are disposed on the driving circuit 120.

As shown in FIG. 1, the display device 100A includes a wire 152 and a display unit 162. The wire 152 is disposed on the driving circuit 120. The wire 152 may penetrate at least one of the insulating layers 122, 124, 126, 128 and 140. The wire 152 is used to electrically connect the driving circuit 120 and the display unit 162. The material of the wire 152 may be the same as or similar to that of the gate electrode 116.

As shown in FIG. 1, at least one display unit 162 may be disposed on the driving circuits 120. A pixel definition layer 154 may be disposed adjacent to the display unit 162. The opening in the pixel definition layer 154 may be regarded as a display region of the display device 100A. The material of the pixel definition layer 154 may include polymer, such as polyethylene terephthalate (PET), polyethylene (PE), polyethersulfone (PES), polycarbonate (PC), polymethylmethacrylate (PMMA) or other suitable materials. In some embodiments, the display unit 162 may have display medium including liquid crystals (LC), inorganic light-emitting diodes, mini light-emitting diodes (mini LED), micro light-emitting diodes (micro LED), quantum dot light-emitting diodes (QDLED), organic light-emitting diodes (OLED), QLED, quantum dots (QD), phosphors, fluorescence or other display elements, and is not limited thereto. For example, the display unit 162 may include a bottom electrode 156, an electroluminescent layer 158 and a top electrode 160. In some examples, the bottom electrode 156 and the wire 152 are integrated. The electroluminescent layer 158 may be disposed between the bottom electrode 156 and the top electrode 160. The material of the bottom electrode 156 and the top electrode 160 may include metal and/or conductive transparent material, the metal may include Cu, Al, Mo, W, Au, Cr, Ni, Pt, Ti or other suitable materials. The material of the bottom electrode 156 may be different from the material of the top electrode 160. The conductive transparent material may include ITO or other suitable materials. In some examples, the bottom electrode 156 may include the wire 152, and the material of the wire 152 may be the same as or similar to the material of the bottom electrode. The electroluminescent layer 158 may include an organic film. As shown in FIG. 1, the top electrode 160 and the inorganic layer 164 may be disposed on the pixel definition layer 154. The display unit 162 may be electrically connected to the driving circuit 120 through the wire 152 and the wire 118. In some embodiments where the display device is an OLED display device, a region of the display unit 162 may be defined by the anode electrode of the display unit 162. In some embodiments where the display device is liquid crystal display, a region of the display unit 162 may be defined by the pixel electrode of the display units 162.

The display device 100A may further include an organic layer 166 and an inorganic layer 168. The organic layer 166 may be disposed on the top electrode 160 of the display unit 162. The inorganic layer 168 may be disposed on the organic layer 166. The organic layer 166 may protect the display unit 162 from moisture of surrounding. The inorganic layer 168 may absorb the stress generated when the display device 100A is bent.

In some embodiments, the display device 100A may include the sensing unit 148 disposed between the pixel definition layer 154 and the driving circuit 120. More specifically, the sensing circuit 138 and the sensing unit 148 may be disposed between the display unit 162 and the driving circuit 120. In other examples, the sensing circuit 138 and the sensing unit 148 may be disposed between the pixel definition layer 154 and the driving circuit 120. As a result, the sensing unit 148 overlaps the semiconductor layer 114 of the driving circuit 120. Therefore, the display device may maintain the high resolution when integrating the sensing functionality in the display area of the display device.

It is appreciated that the cross-sectional view shown in FIG.1 is only an example. In other cross-sections, the layout of the circuit of the display device 100A may have other designs, and the scope of the present disclosure is not limited thereto. For example, the contact of the source/drain region 112 of one of the driving circuit 120 is omitted because that is formed in other cross-sections.

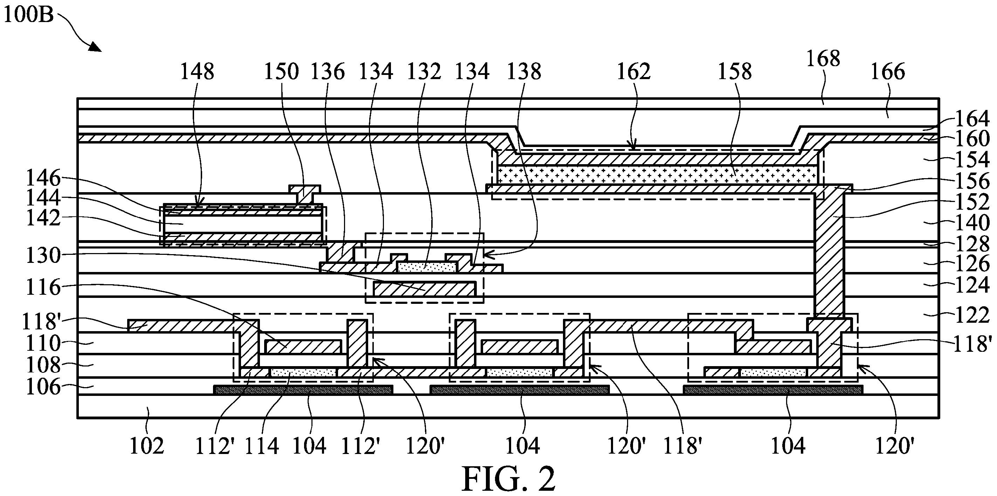

Many variations and/or modifications can be made to embodiments of the disclosure. Refer to FIG. 2, which illustrates a cross-sectional view of a display device 100B in accordance with some embodiments of the present disclosure. In some embodiments, one of the differences between the display device 100B and the display device 100A is that two adjacent driving circuits 120' may be electrically connected by a source/drain region 112'. In some embodiments, a portion of the source/drain region 112' may be used as the source electrode of one driving circuit 120', and a portion of the source/drain region 112' may be used as the drain electrode of another driving circuit 120'. In some embodiments, at least two of the driving circuits 120' may be electrically connected through a wire 118' or through the source/drain region 112'.

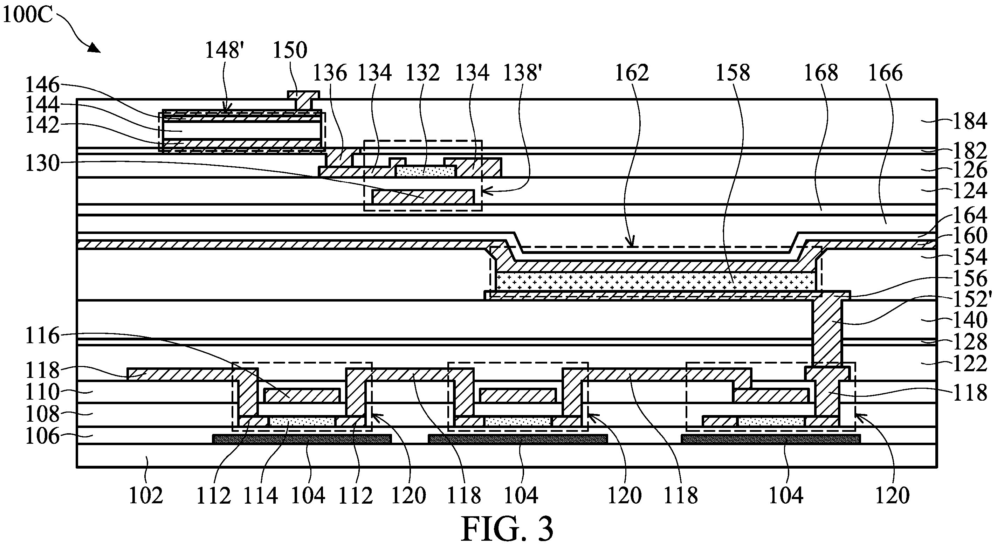

Many variations and/or modifications can be made to embodiments of the disclosure. Refer to FIG. 3, which illustrates a cross-sectional view of a display device 100C in accordance with some embodiments of the present disclosure. In some embodiments, one of the differences between the display device 100C and the display device 100A is that a sensing unit 148' and a sensing circuit 138' of the display device 100C may be disposed on the display unit 162 and/or the pixel definition layer 154. As shown in FIG. 3, the insulating layers 182 and 184 may be disposed on the insulating layer 126. The material of the insulating layers 182 and 184 may be the same as or similar to that of the insulating layers 128 and 140, respectively. The sensing unit 148' may be disposed on the driving circuit 120. In some embodiments, the display unit 162 and/or the pixel definition layer 154 may be disposed between at least one of the sensing circuits 138' and at least one of the driving circuits 120. In some embodiments, the display unit 162 may be disposed between at least one of the sensing units 148' and at least one of the driving circuits 120. In this embodiment, the thickness of the wire 152' may be less than that of the wire 152. In other examples, the thickness of the layers (e.g. layers 122, 128 and 140) penetrated by the wire 152' may be less than that of the wire 152. Accordingly, the formation of the wire 152' may become easier.

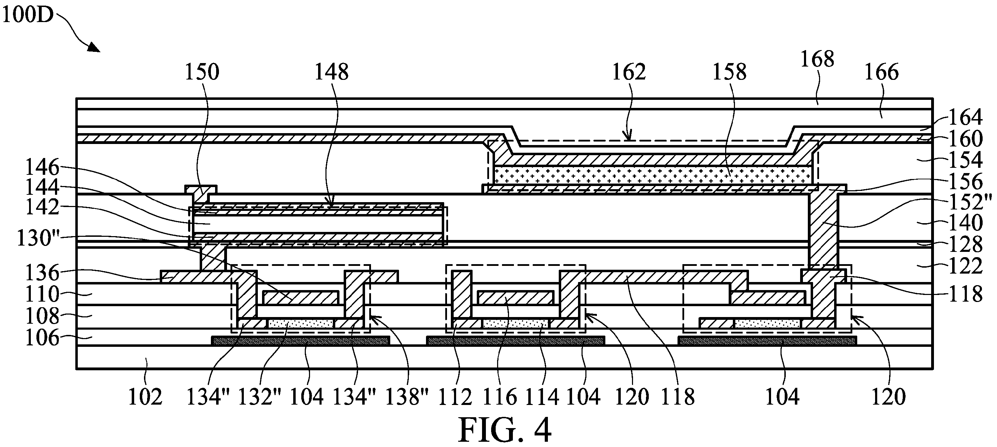

Many variations and/or modifications can be made to embodiments of the disclosure. Refer to FIG. 4, which illustrates a cross-sectional view of a display device 100D in accordance with some embodiments of the present disclosure. In some embodiments, one of the differences between the display device 100D and the display device 100A is that some of the driving circuits 120 may be replaced with sensing circuits 138''. In some embodiments, the sensing circuit 138'' and the driving circuit 120 may be disposed on the same layer. In some embodiments, a gate electrode 130" and a semiconductor layer 132'' of the sensing circuit 138'' may be manufactured in the same processes as the gate electrode 116 and the semiconductor layer 114 of the driving circuit 120, respectively. In this embodiment, a portion of the sensing circuit 138'' may be manufactured in the same process as the driving circuit 120. Accordingly, the processes of forming the sensing circuit 138'' and the driving circuit 120 may be simplified. In some examples, at least one of the driving circuits 120 may serve as the sensing circuit 138''. Furthermore, the thickness of the wire 152" may be less than that of the wire 152. In other examples, the thickness of the layers (e.g. layers 122, 128 and 140) penetrated by the wire 152" may be less than that of the wire 152. Accordingly, the formation of the wire 152'' may become easier.

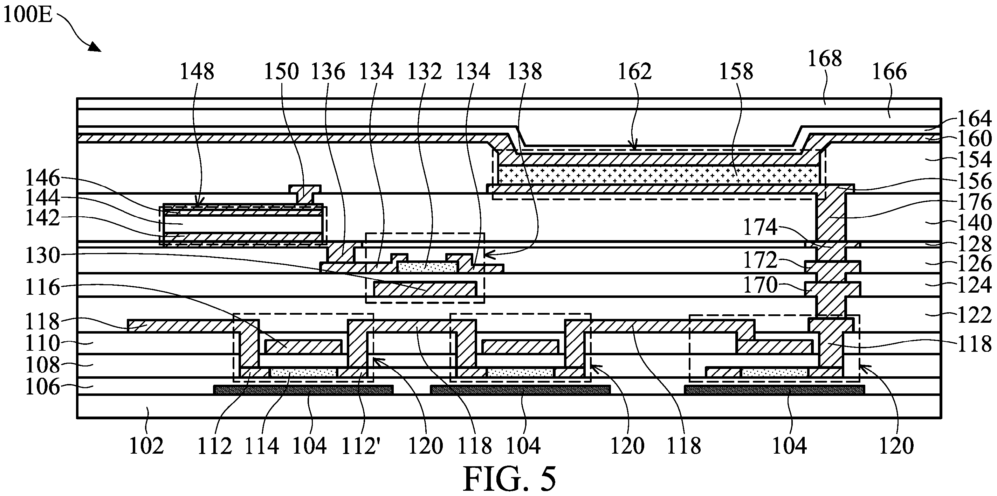

Many variations and/or modifications can be made to embodiments of the disclosure. Refer to FIG. 5, which illustrates a cross-sectional view of a display device 100E in accordance with some embodiments of the present disclosure. In some embodiments, one of the differences between the display device 100E and the display device 100A is that the wire 152 of FIG. 1 may be replaced with at least one of the wires 170, 172, 174 and 176, but it is not limited thereto. For example, at least one of the wires 170, 172, 174 and 176 may be omitted, or other wires may be disposed between two of the wires 170, 172, 174 and 176. In some embodiments, the wires 170, 172, 174 may be manufactured in the same processes as the gate electrode 130, the source/drain region 134 and the wire 136, respectively. The material of the wire 176 may be the same as or similar to the wire 152. In this embodiment, at least one of the driving circuits 120 may be electrically connected to the display unit 162 through the wires 118, 170, 172, 174 and 176. As shown in FIG. 5, the thickness of the wire 176 may be less than that of the wire 152. Accordingly, the formation of the wire 176 may become easier.

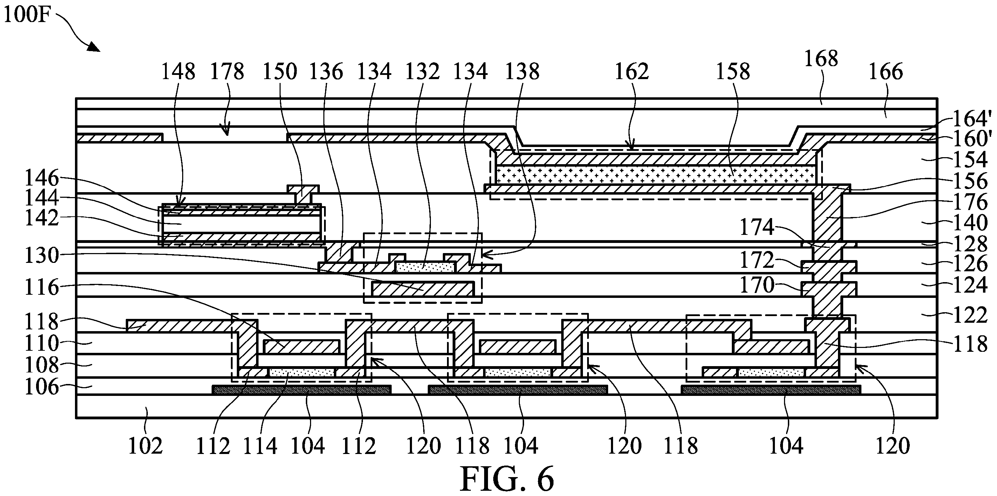

Many variations and/or modifications can be made to embodiments of the disclosure. Refer to FIG. 6, which illustrates a cross-sectional view of a display device 100F in accordance with some embodiments of the present disclosure. In some embodiments, one of the differences between the display device 100F and the display device 100E is that the top electrode 160' of the display device 100F may include at least one opening 178 corresponding to the sensing unit 148. The opening 178 may partially or entirely overlap the sensing unit 148. In some embodiments, a portion of the inorganic layer 164' may be disposed in the opening 178. The opening 178 may assist in improving the efficiency of the sensing unit 148. Accordingly, the performance of the display device 100F may be improved.

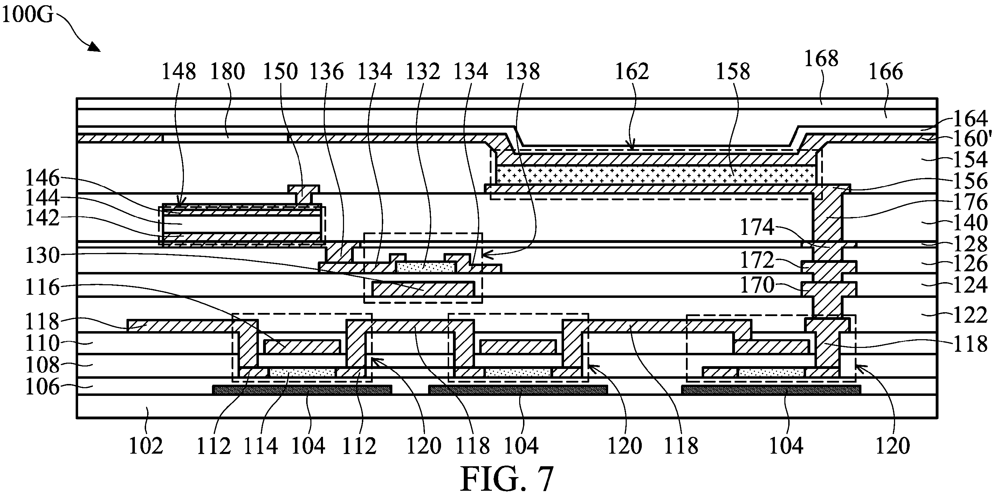

Many variations and/or modifications can be made to embodiments of the disclosure. Refer to FIG. 7, which illustrates a cross-sectional view of a display device 100G in accordance with some embodiments of the present disclosure. In some embodiments, one of the differences between the display device 100G and the display device 100F is that a light conversion layer 180 may be disposed in the opening 178 of the display device 100F. The material of the light conversion layer 180 may include a light filter, a quantum dot, other suitable material, or a combination thereof. For example, the light conversion layer 180 may allow light with specific wavelength to pass through. The light conversion layer 180 may allow the light with specific wavelength to be incident to the sensing unit 148. Accordingly, it may improve the signal-to-noise ratio of the display device 100G.

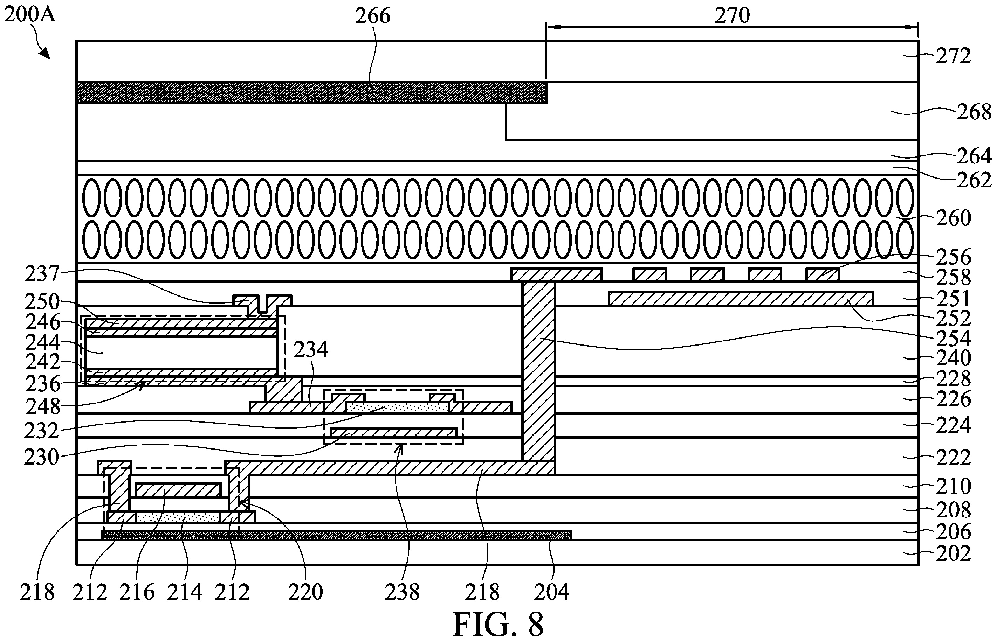

FIG. 8 illustrates a cross-sectional view of a display device 200A in accordance with some embodiments of the present disclosure. The display device 200A may include a substrate 202. The substrate 202 may include a glass substrate, a ceramic substrate, a plastic substrate, and/or other suitable substrates. A light shielding layer 204 may be disposed on the substrate 202. The light shielding layer 204 may be configured to shield at least a portion of light affecting the driving circuits. The material of the light shielding layer 204 may include, but is not limited to, metal, metal oxide, resin, or a combination thereof. At least one of insulating layers 206, 208 and 210 may be sequential disposed on the substrate 202. The material(s) of insulating layers 206, 208 and 210 may include, but is not limited to, silicon nitride, silicon oxide, silicon oxynitride, silicon carbide, other dielectric materials or a combination thereof.

As shown in FIG. 8, the display device 200A may include at least one driving circuit 220. The driving circuit 220 may be used to control a display layer 260. Although FIG. 8 illustrates only one driving circuit 220, the display device 200A may have more driving circuits 220, and the scope of the disclosure is not intended to be limited. The driving circuit 220 may include a semiconductor layer 214, and a gate electrode 216. In some examples, the semiconductor layer 214 may include a source/drain region 212 and a channel region disposed between the source/drain region 212, but it is not limited thereto. In other examples, the semiconductor layer 214 may include a doped region and a non-doped region. The semiconductor layer 214 may be disposed on the insulating layer 206. The gate electrode 216 may be disposed on the insulating layer 208. The materials of the semiconductor layer 214 and the gate electrode 216 may be the same as or similar to those of the semiconductor layer 114 and the gate electrode 116, and are not repeated herein.

The wire 218 and a wire 254 may be used to electrically connect the driving circuit 220 and a pixel electrode 256. The wire 218 may be disposed on the insulating layer 210. Moreover, the wire 218 may penetrate the insulating layer 208 and the insulating layer 210. The wire 254 may be disposed on the insulating layer 210. Furthermore, the wire 254 may penetrate the insulating 222, the insulating layer 224, the insulating layer 226, the insulating layer 228, the insulating layer 240 and the insulating layer 251. The materials of the wire 218 and the wire 254 may be the same as or similar to that of the wire 118.

As shown in FIG. 8, at least one of the insulating layers 222, 224, 226, and 228 may be sequentially disposed on the insulating layer 210. The material of the insulating layers 222, 224, 226, and 228 may be the same as or similar to that of the insulating layer 206, and is not repeated herein.

In some embodiments, the display device 200A may include a sensing circuit 238. The sensing circuit 238 may be disposed on the driving circuit 220. The sensing circuit 238 may include a gate electrode 230, a semiconductor layer 232. In some examples, the semiconductor layer 232 may include a source/drain region 234 and a channel region disposed between the source/drain region 234, but it is not limited thereto. In other examples, the semiconductor layer 232 may include a doped region and a non-doped region. The sensing circuit 238 may be used to drive at least one of the sensing units. The gate electrode 230 may be disposed on the insulating layer 222. The source/drain region 234 may be disposed on the insulating layer 224. The material of the gate electrode 230 may be the same as or similar to that of the gate electrode 130. The material of the semiconductor layer 232 may be the same as or similar to that of the semiconductor layer 132.

As shown in FIG. 8, an insulating layer 240 is disposed on the insulating layer 228. The material of the insulating layer 240 may include, but is not limited to, polyethylene terephthalate (PET), polyethylene (PE), polyethersulfone (PES), polycarbonate (PC), polymethylmethacrylate (PMMA), glass, any other suitable materials, or a combination thereof. In addition, an insulating layer 251 may be disposed on the insulating layer 240. The material of the insulating layer 251 may include low dielectric constant materials.

In some embodiments, the display device 200A may include at least one sensing unit 248 disposed on the driving circuit 220. The sensing unit 248 may be used to sense a photonic signal from an object (e.g., a fingerprint) and convert it into an electrical signal, but it is not limited thereto. Although FIG. 8 illustrates only one sensing unit 248, the display device 200A may have more sensing units 248, and the scope of the disclosure is not intended to be limited. As shown in FIG. 8, the sensing unit 248 includes a semiconductor layer 242, a photoactive layer 244, and a semiconductor layer 246. The sensing unit 248 may further include an upper electrode 250 and a lower electrode 236. The structure and the material of the sensing unit 248 may be the same as or similar to those of the sensing unit 148, and it will not be repeated herein. As shown in FIG. 8, the sensing unit 248 may be electrically connected to the sensing circuit 238 through the lower electrode 236. The sensing unit 248 may be electrically connected to other electronic elements through the upper electrode 250 and a wire 237. The material of the wire 237 may be the same as or similar to that of the wire 152.

In some embodiments, the sensing unit 248 may overlap the driving circuit 220. More specifically, the sensing unit 248 may partially or entirely overlap the semiconductor layer 214 of the driving circuit 220. Namely, the projection of the sensing unit 248 on the substrate 202 may overlap the projection of the semiconductor layer 214 on the substrate 202. In some embodiments, the sensing unit 248 and the driving circuit 220 may not be disposed on the same layer. As a result, this assists in reducing the size of the display device 200A. In some embodiments, the sensing circuit 238 may be disposed between the driving circuit 220 and the sensing unit 248. In some embodiments, both the sensing circuit 238 and the sensing unit 248 may be disposed on the driving circuit 220.

In some embodiments, the display device 200A may include a common electrode 252 and a pixel electrode 256. The common electrode 252 may be disposed on the insulating layer 240. The pixel electrode 256 may be disposed on the insulating layer 251. The common electrode 252, the pixel electrode 256 and the insulating layer 251 may form a capacitor. The voltage difference between the common electrode 252 and the pixel electrode 256 may be used to control the display layer 260. The voltage of the pixel electrode 256 may be controlled by the driving circuit 220.

As shown in FIG. 8, the display device 200A may include a polymer layer 258, the display layer 260, and a polymer layer 262. The display layer 260 may be disposed between the polymer layer 258 and the polymer layer 262, and the display layer 260 may include a liquid crystal layer or other suitable display layer. The display device 200A may include, but is not limited to, a twisted nematic (TN) liquid-crystal display device, a super twisted nematic (STN) liquid-crystal display device, a double layer super twisted nematic (DSTN) liquid-crystal display device, a vertical alignment (VA) liquid-crystal display device, an in-plane switching (IPS) liquid-crystal display device, a cholesteric liquid-crystal display device, a blue phase liquid-crystal display device, a fringe-field switching (FFS) liquid-crystal display device, or any other suitable liquid-crystal display device.

The display device 200A may include an overcoat layer 264, a light shielding layer 266 and a color filter 268. The material of the overcoat layer 264 may include phosphosilicate glass (PSG), borophosphosilicate glass (BPSG), low dielectric constant (low-k) material and/or other suitable material(s). The low dielectric constant dielectric materials may include, but are not limited to, fluorinated silica glass (FSG), carbon doped silicon oxide, amorphous fluorinated carbon, parylene, bis-benzocyclobutenes (BCB), polyimides, or other suitable materials. The light shielding layer 266 and the color filter 268 may be disposed between the overcoat layer 264 and a substrate 272. The color filter 268 may allow light with specific wavelength to pass through. For example, the color filter 268 may include, but is not limited to, a red color filter, a green color filter, a blue color filter or an IR color filter. The material of the light shielding layer 266 may be the same as or similar to that of the light shielding layer 204. The display device 200A may include a display unit 270. In some embodiments, one light-emitting region may be regarded as the display unit 270 of the display device 200A. It should be appreciated that the display unit 270 shown in FIG. 8 is merely an example, and the present disclosure is not limited thereto. The substrate 272 may include a glass substrate, a ceramic substrate, a plastic substrate, and/or other suitable substrates.

In some embodiments, the display device 200A may include the sensing unit 248 disposed between the display layer 260 and the driving circuit 220. More specifically, the sensing circuit 238 and the sensing unit 248 may be disposed between the display layer 260 and the driving circuit 220. As a result, the sensing unit 248 may overlap the semiconductor layer 214 of the driving circuit 220, and the size of the display device 200A is reduced.

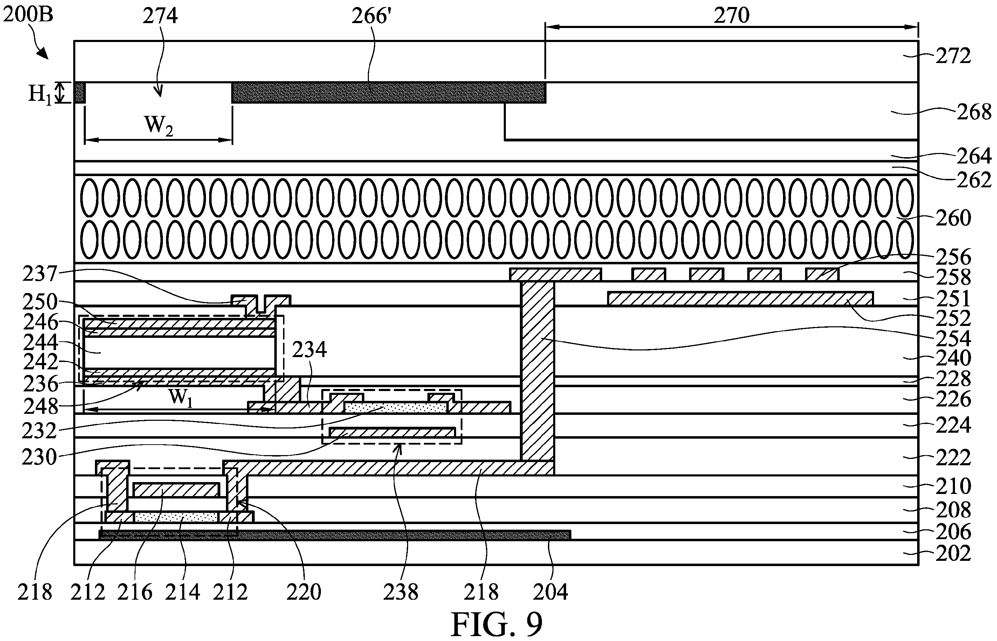

Many variations and/or modifications can be made to embodiments of the disclosure. Refer to FIG. 9, which illustrates a cross-sectional view of a display device 200B in accordance with some embodiments of the present disclosure. In some embodiments, one of the differences between the display device 200B and the display device 200A is that a light shielding layer 266' of the display device 200B may include an opening 274 corresponding to the sensing unit 248. As shown in FIG. 9, the opening 274 of the light shielding layer 266' may be filled with the overcoat layer 264. In some embodiments, the sensing unit 248 has a first width W₁ and the opening 274 has a second width W₂ in the cross sectional view. The first width W₁ and the second width W₂ may be measure along a direction perpendicular to the normal direction of the substrate 202. The second width W₂ may be less than the first width W₁. The opening 274 may assist in improving the efficiency of the sensing unit 248. Accordingly, the performance of the display device 200B may be improved. Furthermore, the light shielding layer 266' may have a height H₁. In some embodiments, the height H₁ may be greater than 5µm. If height H₁ of the light shielding layer 266' is greater than 5µm, the performance of the display device 200B may be improved.

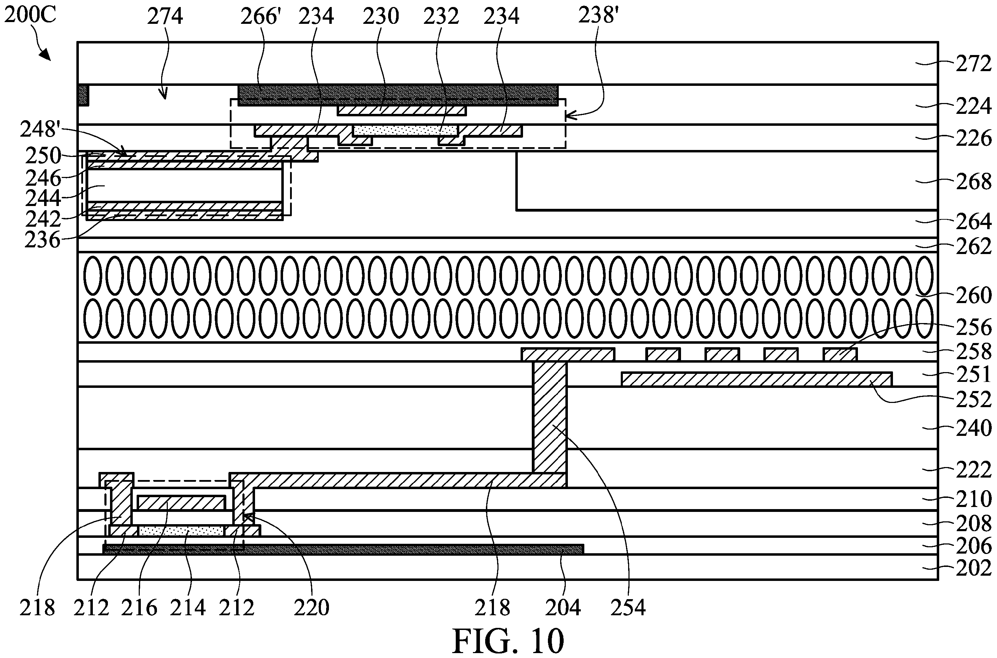

Many variations and/or modifications can be made to embodiments of the disclosure. Refer to FIG. 10, which illustrates a cross-sectional view of a display device 200C in accordance with some embodiments of the present disclosure. In some embodiments, one of the differences between the display device 200C and the display device 200B is that a sensing unit 248' and a sensing circuit 238' may be disposed on the display layer 260. The display layer 260 may be disposed between the sensing unit 248' and the driving circuit 220. As shown in FIG. 10, the sensing unit 248' may be embedded in the overcoat layer 264. In some embodiments, the sensing unit 248' and the color filter 268 may be disposed on the same layer. In some embodiments, the sensing circuit 238' may be disposed on the sensing unit 248'. The sensing circuit 238' may be at least partially covered by the light shielding layer 266'. As shown in FIG. 10, the sensing unit 248' may be exposed from the opening 274 of the light shielding layer 266'. Since a portion of the space of the overcoat layer 264 is used to form the sensing unit 248', the size of the display device 200C may be reduced.

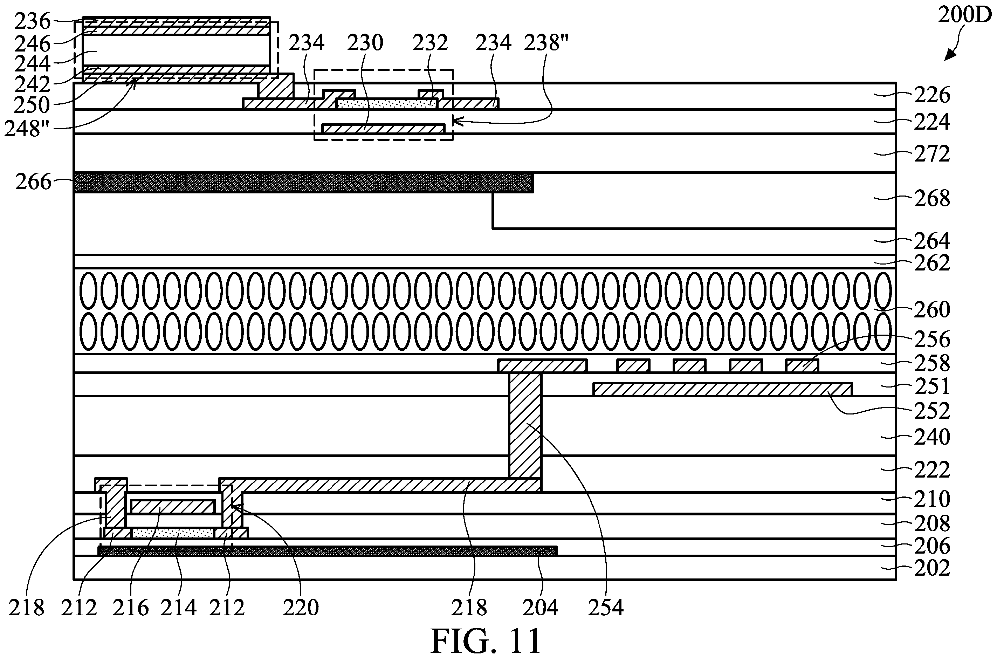

Many variations and/or modifications can be made to embodiments of the disclosure. Refer to FIG. 11, which illustrates a cross-sectional view of a display device 200D in accordance with some embodiments of the present disclosure. In some embodiments, one of the differences between the display device 200D and the display device 200A is that the sensing circuit 238" and the sensing unit 248" may be disposed on the substrate 272. The color filter 268 may be disposed between the sensing unit 248" and the driving circuit 220.

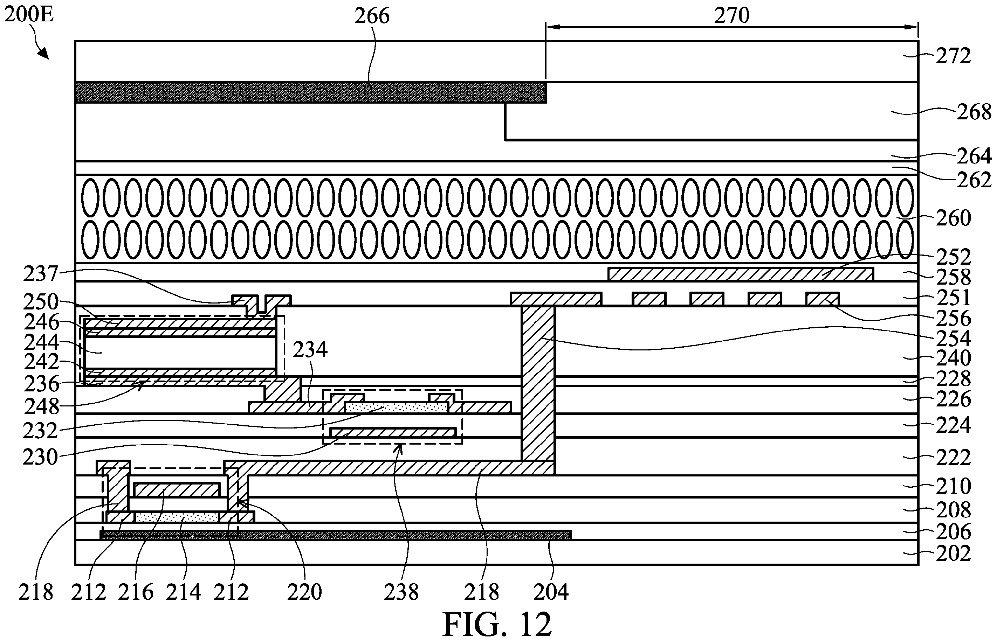

Many variations and/or modifications can be made to embodiments of the disclosure. Refer to FIG. 12, which illustrates a cross-sectional view of a display device 200E in accordance with some embodiments of the present disclosure. In some embodiments, one of the differences between the display device 200E and the display device 200A is that the common electrode 252 is disposed on the insulating layer 251 and on the pixel electrode 256. The common electrode 252 may be disposed between the polymer layer 258 and the insulating layer 251.

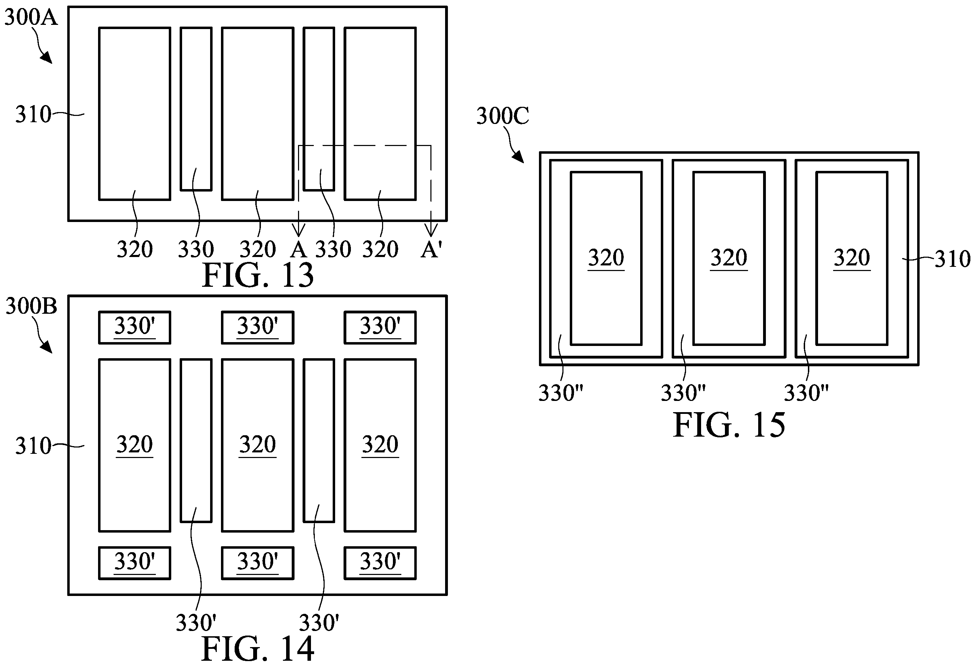

FIG. 13 illustrates a top view of a display device 300A in accordance with some embodiments of the present disclosure. As shown in FIG. 13, the display device 300A may include a substrate 310. In addition, the display device may include a plurality of display regions 320 and a plurality of sensing regions 330. In some embodiments, at least one of the sensing regions 330 may be disposed between two adjacent display regions 320. The display region 320 may be a sub-pixel, such as a red sub-pixel, a blue sub-pixel, a green sub-pixel or an IR sub-pixel of the display device 300A. However, the scope of the disclosure is not intended to be limited. In some embodiments, the display region 320 may correspond to the region on which the display unit 162 of FIG. 1 is disposed. The sensing region 330 may correspond to the region on which the sensing unit 148 of FIG. 1 is disposed. For example, FIG. 1 may be a cross sectional view along line A-A' shown in FIG. 13.

In some embodiments, the display region 320 may correspond to the region on which the display unit 270 of FIG. 8 is disposed. The sensing region 330 may correspond to the region on which the sensing unit 248 of FIG. 8 is disposed. For example, FIG. 8 may be a cross sectional view along line A-A' shown in FIG. 13.

FIG. 13 illustrates the display region 320 and the sensing region 330 having rectangular profiles. In some other embodiments, the display region 320 and the sensing region 330 may have other profiles, and the scope of the disclosure is not intended to be limited.

FIG. 14 illustrates a top view of a display device 300B in accordance with some embodiments of the present disclosure. In some embodiments, one of the differences between the display device 300B and the display device 300A is that the display device 300B may have a plurality of sensing regions 330' disposed adjacent to at least one of the display regions 320. The sensing regions 330' may have different areas and/or profiles, and the scope of the disclosure is not intended to be limited.

FIG. 15 illustrates a top view of a display device 300C in accordance with some embodiments of the present disclosure. In some embodiments, one of the differences between the display device 300C and the display device 300A is that the sensing region 330" may be disposed around the display region 320. The sensing region 330'' may include a plurality of sections (not shown). In some examples, the sensing region 330" of the display device 300C may overlap the display region 320. In some embodiments, the area of the display region 320 may be less than that of the sensing region 330 from the top view. However, the scope of the disclosure is not intended to be limited. In some embodiments, the area of the display region 320 may be greater than that of the sensing region 330 from the top view.

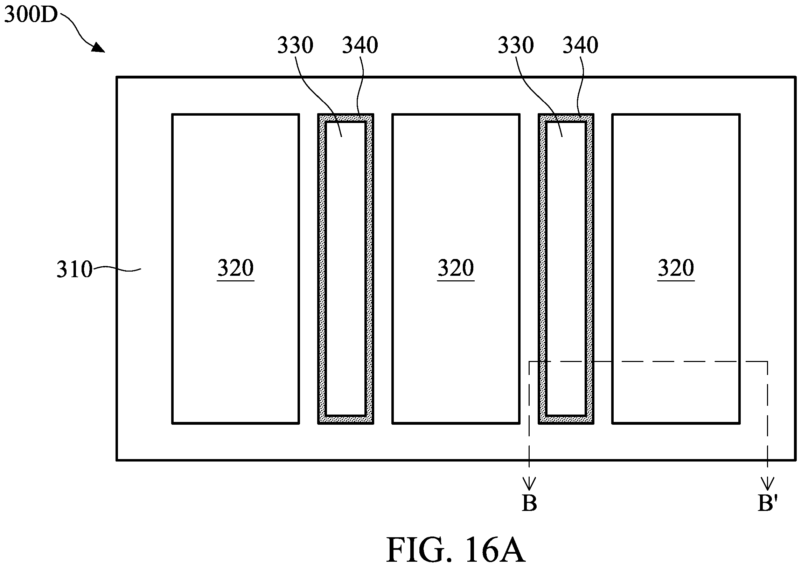

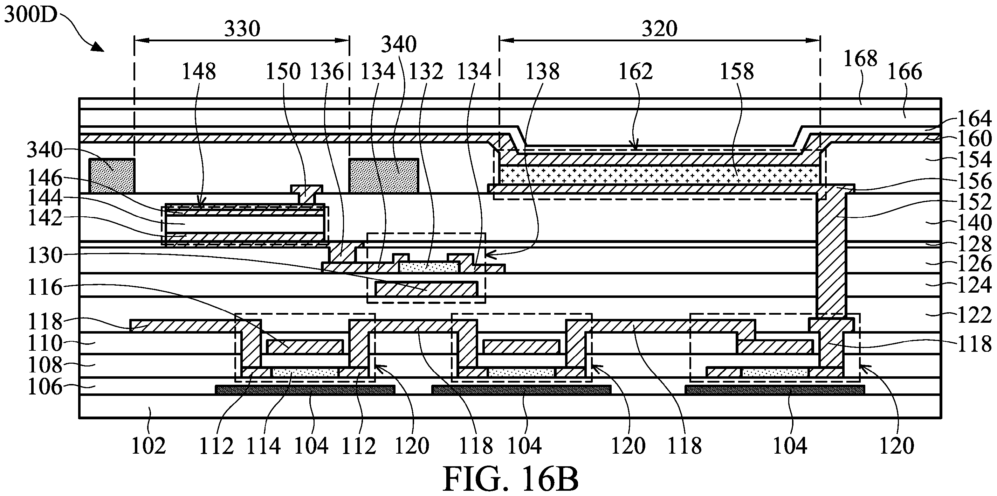

FIG. 16A illustrates a top view of a display device 300D in accordance with some embodiments of the present disclosure. In some embodiments, one of the differences between the display device 300D and the display device 300A is that the display device 300D may further include a light shielding layer 340 disposed adjacent to the sensing region 330. Refer to FIG. 16B, which is a cross-sectional view along line B-B' of display device 300D shown in FIG. 16A. As shown in FIG. 16B, the light shielding layer 340 may be disposed on the insulating layer 140. In some embodiments, the light shielding layer 340 and the display unit 162 may be disposed on the same layer. It should be appreciated that the light shielding layer 340 may also be disposed on the structures shown in FIGs. 2-12, and the scope of the disclosure is not intended to be limited. The formation of the light shielding layer 340 may improve the signal-to-noise ratio of the display device 300D.

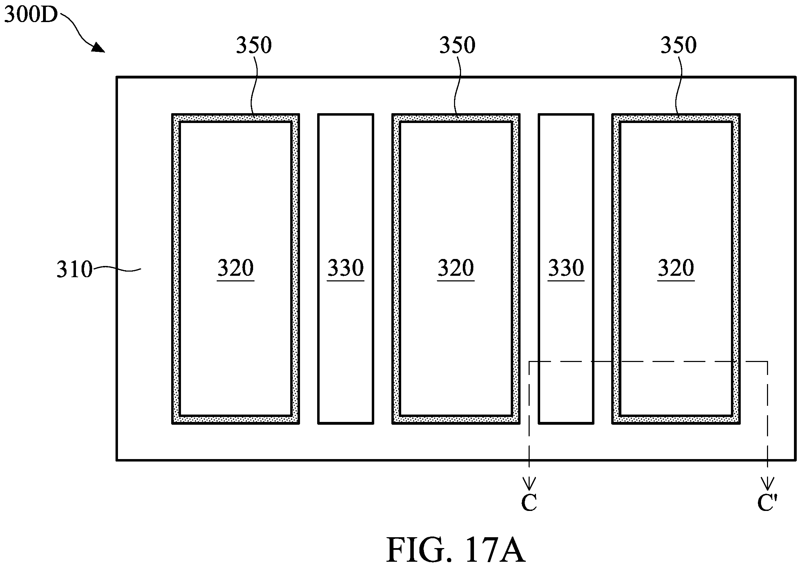

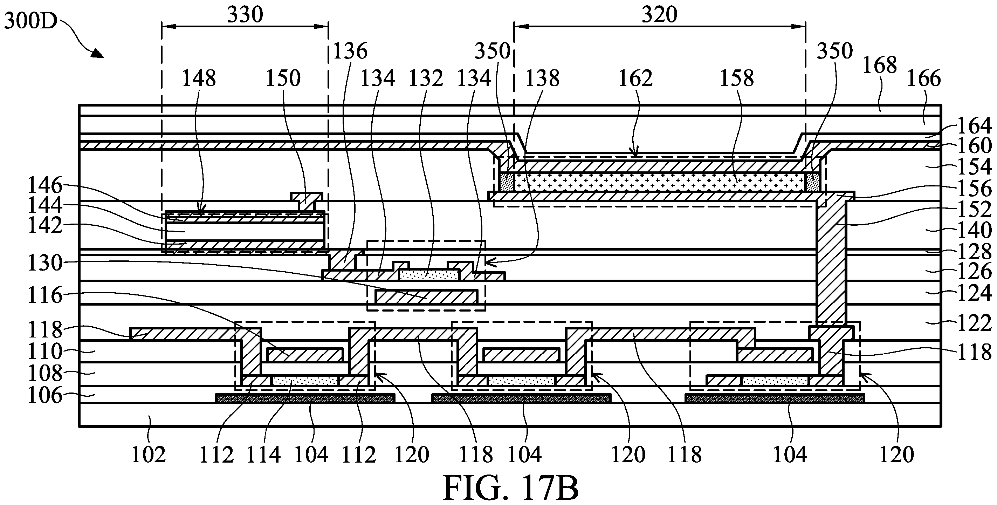

FIG. 17A illustrates a top view of a display device 300E in accordance with some embodiments of the present disclosure. In some embodiments, one of the differences between the display device 300E and the display device 300A is that the display device 300E may further include a light shielding layer 350 disposed adjacent to the display region 320. Refer to FIG. 17B, which is a cross-sectional view along line C-C' of display device 300E shown in FIG. 17A. As shown in FIG. 17B, the light shielding layer 350 may be disposed between the bottom electrode 156 and the top electrode 160. In some embodiments, the electroluminescent layer 158 may be surrounded by the light shielding layer 350. It should be appreciated that the light shielding layer 350 may also be disposed on the structures shown in FIGs. 2-12, and the scope of the disclosure is not intended to be limited. The formation of the light shielding layer 350 may improve the signal-to-noise ratio of the display device 300E.

It should be appreciated that a display device may have a plurality of display units. The display units may be formed in different positions. For example, the display device may have a first display unit as shown in FIG. 1, and may have a second display unit as shown in FIG. 4. The scope of the disclosure is not intended to be limited.

Although some embodiments of the present disclosure and their advantages have been described in detail, it should be understood that various changes, substitutions and alterations can be made herein without departing from the scope of the disclosure as defined by the appended claims.

## Claims

1. A display device (100A-G; 200A-E; 300A-D), comprising:
a substrate (102);
a driving circuit (120) disposed on the substrate and comprising a semiconductor layer (114);
a plurality of sensing units (148) disposed on the driving circuit;
a plurality of display units (162) driven by the driving circuit;
a sensing circuit (138) electrically connected to at least one of the plurality of sensing units (148);
wherein at least one of the plurality of sensing units (148) overlaps the semiconductor layer (114) of the driving circuit (120) and at least a portion of the sensing circuit (138) overlaps at least a portion of the driving circuit (120);
wherein the plurality of sensing units (148) are disposed between the driving circuit (120) and the plurality of display units (162); and
a wire (152) disposed on the driving circuit (120), wherein the wire (152) electrically connects the driving circuit (120) and the plurality of display units (162).

2. The display device as claimed in claim 1, wherein the sensing circuit (138) is disposed on the driving circuit.

3. The display device as claimed in one of the preceding claims, wherein at least one of the plurality of sensing units (148) does not overlap the plurality of display units.

4. The display device as claimed in one of the preceding claims, further comprising:
an insulating layer (126) disposed on the plurality of display units, wherein the insulating layer comprises at least one opening corresponding to the at least one of the plurality of sensing units.

5. The display device as claimed in one of the preceding claims, further comprising:
a display layer (260) disposed on the driving circuit; and
a color filter (268) disposed on the display layer.

6. The display device as claimed in claim 5, further comprising:
a light shielding layer (266') disposed on the display layer, wherein the light shielding layer has an opening (274) corresponding to at least one of the plurality of sensing units;
wherein the at least one of the plurality of sensing units (148) have a first width, the opening has a second width, and the first width is greater than the second width.

7. The display device as claimed in claim 5, wherein a portion of the plurality of sensing units (148) and the color filter are disposed on a same layer.

8. The display device as claimed in claim 5, wherein the display layer (260) is disposed between the driving circuit and the plurality of sensing units.

9. The display device as claimed in claim 5, further comprising:
a common electrode (252) disposed on the driving circuit; and
a pixel electrode (256) disposed on the common electrode and electrically connected to the driving circuit;
wherein the common electrode (252) is disposed between the pixel electrode and the display layer.

10. The display device as claimed in one of the preceding claims, further comprising:
a light shielding layer (340) disposed on the plurality of sensing units, wherein the light shielding layer and the plurality of display units (162) are disposed on a same layer.

11. The display device as claimed in one of claims 1-9, further comprising:
a light shielding layer (350) disposed on the plurality of sensing units, wherein the light shielding layer is disposed adjacent to at least one of the plurality of display units.

12. The display device as claimed in one of the preceding claims, wherein at least one of the plurality of sensing units is disposed between two adjacent display units.

## Patentansprüche

1. Anzeigevorrichtung (100A-G; 200A-E; 300A-D), umfassend:
ein Substrat (102);
eine Treiberschaltung (120), die auf dem Substrat angeordnet ist und eine Halbleiterschicht (114) umfasst;
eine Vielzahl von Abstasteinheiten (148), die auf der Treiberschaltung angeordnet sind;
eine Vielzahl von Anzeigeeinheiten (162), die von der Treiberschaltung angesteuert werden;
eine Abtastschaltung (138), die mit mindestens einer der mehreren Abtasteinheiten (148) elektrisch verbunden ist;
wobei mindestens eine der Vielzahl von Abstasteinheiten (148) die Halbleiterschicht (114) der Treiberschaltung (120) überlappt und mindestens ein Teil der Abstastschaltung (138) mindestens einen Teil der Treiberschaltung (120) überlappt;
wobei die Vielzahl von Abstasteinheiten (148) zwischen der Treiberschaltung (120) und der Vielzahl von Anzeigeeinheiten (162) angeordnet ist; und
eine Leitung (152), die auf der Treiberschaltung (120) angeordnet ist, wobei die Leitung (152) die Treiberschaltung (120) und die Vielzahl von Anzeigeeinheiten (162) elektrisch verbindet.

2. Anzeigevorrichtung nach Anspruch 1, wobei die Abtastschaltung (138) auf der Treiberschaltung angeordnet ist.

3. Anzeigevorrichtung nach einem der vorhergehenden Ansprüche, wobei mindestens eine der mehreren Abstasteinheiten (148) die mehreren Anzeigeeinheiten nicht überlappt.

4. Anzeigevorrichtung nach einem der vorangehenden Ansprüche, ferner umfassend:
eine Isolierschicht (126), die auf der Vielzahl von Anzeigeeinheiten angeordnet ist, wobei die Isolierschicht mindestens eine Öffnung aufweist, die der mindestens einen der Vielzahl von Abstasteinheiten entspricht.

5. Anzeigevorrichtung nach einem der vorangehenden Ansprüche, ferner umfassend:
eine Anzeigeschicht (260), die auf der Treiberschaltung angeordnet ist; und
einen Farbfilter (268), der auf der Anzeigeschicht angeordnet ist.

6. Anzeigevorrichtung nach Anspruch 5, ferner umfassend:
eine Lichtabschirmungsschicht (266'), die auf der Anzeigeschicht angeordnet ist, wobei die Lichtabschirmungsschicht eine Öffnung (274) aufweist, die mindestens einer der mehreren Abstasteinheiten entspricht;
wobei die mindestens eine der Vielzahl von Abstasteinheiten (148) eine erste Breite hat, die Öffnung eine zweite Breite hat und die erste Breite größer als die zweite Breite ist.

7. Anzeigevorrichtung nach Anspruch 5, wobei ein Teil der Vielzahl von Abstasteinheiten (148) und der Farbfilter auf einer gleichen Schicht angeordnet sind.

8. Anzeigevorrichtung nach Anspruch 5, wobei die Anzeigeschicht (260) zwischen der Ansteuerungsschaltung und der Vielzahl von Abstasteinheiten angeordnet ist.

9. Anzeigevorrichtung nach Anspruch 5, ferner umfassend:
eine gemeinsame Elektrode (252), die auf der Treiberschaltung angeordnet ist; und
eine Pixelelektrode (256), die auf der gemeinsamen Elektrode angeordnet und elektrisch mit der Treiberschaltung verbunden ist;
wobei die gemeinsame Elektrode (252) zwischen der Pixelelektrode und der Anzeigeschicht angeordnet ist.

10. Anzeigevorrichtung nach einem der vorangehenden Ansprüche, ferner umfassend
eine Lichtabschirmungsschicht (340), die auf der Vielzahl von Abtasteinheiten angeordnet ist, wobei die Lichtabschirmungsschicht und die Vielzahl von Anzeigeeinheiten (162) auf einer gleichen Schicht angeordnet sind.

11. Anzeigevorrichtung nach einem der Ansprüche 1-9, ferner umfassend:
eine Lichtabschirmungsschicht (350), die auf der Vielzahl von Abtasteinheiten angeordnet ist, wobei die Lichtabschirmungsschicht benachbart zu mindestens einer der Vielzahl von Anzeigeeinheiten angeordnet ist.

12. Anzeigevorrichtung nach einem der vorangehenden Ansprüche, wobei mindestens eine der Vielzahl von Abstasteinheiten zwischen zwei benachbarten Anzeigeeinheiten angeordnet ist.

## Revendications

1. Dispositif d'affichage (100A-G; 200A-E; 300A-D), comprenant:
un substrat (102);
un circuit d'attaque (120) disposé sur le substrat et comprenant une couche semi-conductrice (114);
une pluralité d'unités de balayage (148) disposées sur le circuit d'attaque;
une pluralité d'unités d'affichage (162) commandées par le circuit de commande;
un circuit de balayage (138) connecté électriquement à au moins une de la pluralité d'unités de balayage (148);
dans lequel au moins une de la pluralité d'unités de balayage (148) chevauche la couche semi-conductrice (114) du circuit d'attaque (120) et au moins une partie du circuit de balayage (138) chevauche au moins une partie du circuit d'attaque (120);
dans lequel la pluralité d'unités de balayage (148) est disposée entre le circuit d'attaque (120) et la pluralité d'unités d'affichage (162); et
une ligne (152) disposée sur le circuit de commande (120), la ligne (152) connectant électriquement le circuit de commande (120) et la pluralité d'unités d'affichage (162).

2. Dispositif d'affichage selon la revendication 1, dans lequel le circuit de balayage (138) est disposé sur le circuit d'attaque.

3. Dispositif d'affichage selon l'une quelconque des revendications précédentes, dans lequel au moins l'une de la pluralité d'unités de balayage (148) ne chevauche pas la pluralité d'unités d'affichage.

4. Dispositif d'affichage selon l'une quelconque des revendications précédentes, comprenant en outre:
une couche isolante (126) disposée sur ladite pluralité d'unités d'affichage, ladite couche isolante ayant au moins une ouverture correspondant à ladite au moins une de ladite pluralité d'unités de balayage.

5. Dispositif d'affichage selon l'une quelconque des revendications précédentes, comprenant en outre:
une couche d'affichage (260) disposée sur le circuit d'attaque; et
un filtre de couleur (268) disposé sur la couche d'affichage.

6. Dispositif d'affichage selon la revendication 5, comprenant en outre:
une couche de protection contre la lumière (266') disposée sur la couche d'affichage, la couche de protection contre la lumière comprenant une ouverture (274) correspondant à au moins une de la pluralité d'unités de balayage;
dans lequel ladite au moins une de ladite pluralité d'unités de détection (148) a une première largeur, ladite ouverture a une seconde largeur, et ladite première largeur est supérieure à ladite seconde largeur.

7. Dispositif d'affichage selon la revendication 5, dans lequel une partie de la pluralité d'unités de balayage (148) et le filtre coloré sont disposés sur une même couche.

8. Dispositif d'affichage selon la revendication 5, dans lequel la couche d'affichage (260) est disposée entre le circuit d'attaque et la pluralité d'unités de balayage.

9. Dispositif d'affichage selon la revendication 5, comprenant en outre:
une électrode commune (252) disposée sur le circuit d'attaque; et
une électrode de pixel (256) disposée sur l'électrode commune et connectée électriquement au circuit d'attaque;
dans lequel l'électrode commune (252) est disposée entre l'électrode de pixel et la couche d'affichage.

10. Dispositif d'affichage selon l'une quelconque des revendications précédentes, comprenant en outre
une couche de protection contre la lumière (340) disposée sur ladite pluralité d'unités de balayage, ladite couche de protection contre la lumière et ladite pluralité d'unités d'affichage (162) étant disposées sur une même couche.

11. Dispositif d'affichage selon l'une quelconque des revendications 1 à 9, comprenant en outre:
une couche de protection contre la lumière (350) disposée sur la pluralité d'unités de balayage, la couche de protection contre la lumière étant disposée de manière adjacente à au moins une de la pluralité d'unités d'affichage.

12. Dispositif d'affichage selon l'une quelconque des revendications précédentes, dans lequel au moins une unité de la pluralité d'unités de balayage est disposée entre deux unités d'affichage adjacentes.
